# EUROPEAN PATENT APPLICATION

(11) **EP 4 654 758 A1**
(43) Date of publication of application: **26.11.2025**
(21) Application number: 24753483.7
(22) Date of filing: 11.01.2024
(51) Int. Cl.: H05K 1/11, H05K 3/32, H05K 3/28, H04M 1/02, H05K 1/18

(54) **CIRCUIT BOARD ASSEMBLY AND ELECTRONIC DEVICE INCLUDING SAME**

(30) Priority: 06.02.2023 KR 20230015458; 22.02.2023 KR 20230023742
(71) Applicant: Samsung Electronics Co., Ltd., Suwon-si, Gyeonggi-do 16677 (KR)
(72) Inventor: LEE, Jongbum, Suwon-si Gyeonggi-do 16677 (KR); KWON, Sera, Suwon-si Gyeonggi-do 16677 (KR); LEE, Byunghoon, Suwon-si Gyeonggi-do 16677 (KR); BANG, Jungje, Suwon-si Gyeonggi-do 16677 (KR); SONG, Chagyu, Suwon-si Gyeonggi-do 16677 (KR)
(74) Representative: Gulde & Partner
(86) International application number: PCT/KR2024/000521
(87) International publication number: WO 2024/167151

(57) **Abstract**

According to an embodiment of the present disclosure, an electronic device may comprise: a housing; a first substrate disposed in the housing and including at least one first pad; a first layer disposed on the first substrate and including at least one first receiving portion; an electric component disposed in the housing and including at least one second pad disposed to correspond to the at least one first pad; a second layer disposed on the electric component, stacked on the first layer, and including at least one second receiving portion; a conductive member configured to electrically connect the at least one first pad and the at least one second pad; and first bonding resin disposed in the at least one first receiving portion and the at least one second receiving portion. Various other embodiments may be possible.

## Description

### [Technical Field]

Various embodiments of the disclosure relate to an electronic device, e.g., a circuit board assembly and an electronic device including the same.

### [Background Art]

Advancing information communication and semiconductor technologies accelerate the spread and use of various electronic devices. In particular, recent electronic devices are being developed to carry out communication while carried on.

The term "electronic device" may mean a device performing a particular function according to its equipped program, such as a home appliance, an electronic scheduler, a portable multimedia player, a mobile communication terminal, a tablet PC, a video/sound device, a desktop PC or laptop computer, a navigation for automobile, etc. For example, the electronic devices may output stored information as voices or images. As electronic devices are highly integrated, and high-speed, high-volume wireless communication becomes commonplace, an electronic device, such as a mobile communication terminal, is recently being equipped with various functions. For example, an electronic device comes with the integrated functionality, including an entertainment function, such as playing video games, a multimedia function, such as replaying music/videos, a communication and security function, such as for mobile banking, and a scheduling or e-wallet function. These electronic devices have been downsized to be conveniently carried by users.

The above-described information may be provided as related art for the purpose of helping understanding of the disclosure. No claim or determination is made as to whether any of the foregoing is applicable as background art in relation to the disclosure.

### [Detailed Description of the Invention]

### [Technical Solution]

According to an embodiment of the disclosure, an electronic device may comprise a housing, a first substrate, a first layer, an electrical component, a second layer, a conductive member, or a first bonding resin. The first substrate may be disposed inside the housing. The first substrate may include at least one first pad. The first layer may be disposed on the first substrate. The first layer may include at least one first receiving portion. The electrical component may be disposed inside the housing. The electrical component may include at least one second pad positioned corresponding to the at least one first pad. The second layer may be disposed on the electrical component. The second layer may be stacked on the first layer. The second layer may include at least one second receiving portion. The conductive member may be configured to electrically connect the at least one first pad and the at least one second pad. The first bonding resin may be disposed in the at least one first receiving portion and the at least one second receiving portion.

According to an embodiment of the disclosure, a circuit board assembly may comprise a first substrate, a first layer, an electrical component, a second layer, a conductive member, or a first bonding resin. The first substrate may include at least one first pad. The first layer may be disposed on the first substrate. The first layer may include at least one first receiving portion. The electrical component may include at least one second pad positioned corresponding to the at least one first pad. The second layer may be disposed on the electrical component. The second layer may be stacked on the first layer. The second layer may include at least one second receiving portion. The conductive member may be configured to electrically connect the at least one first pad and the at least one second pad. The first bonding resin may be disposed in the at least one first receiving portion and the at least one second receiving portion.

According to an embodiment of the disclosure, a method for manufacturing a circuit board assembly may comprise preparing a first substrate on which a first layer having at least one first receiving portion is stacked. The method for manufacturing the circuit board assembly may include disposing a resin on an upper portion of the first layer. The method for manufacturing the circuit board assembly may comprise preparing an electrical component on which a second layer having at least one second receiving portion is stacked. The method for manufacturing the circuit board assembly may comprise aligning the electrical component on an upper portion of the first substrate. The method for manufacturing the circuit board assembly may comprise thermally compressing the first substrate and the electrical component.

### [Brief Description of Drawings]

FIG. 1 is a block diagram illustrating an electronic device in a network environment according to an embodiment;
FIG. 2 is a front perspective view illustrating an electronic device according to an embodiment of the disclosure;
FIG. 3 is a rear perspective view illustrating an electronic device according to an embodiment of the disclosure;
FIG. 4 is a front exploded perspective view illustrating an electronic device according to an embodiment of the disclosure;
FIG. 5 is a rear exploded perspective view illustrating an electronic device according to an embodiment of the disclosure;
FIG. 6 is a cross-sectional view illustrating a circuit board assembly according to an embodiment of the disclosure;
FIG. 7 is an enlarged view of part A of FIG. 6 according to an embodiment of the disclosure;
FIG. 8 is a plan view illustrating a first substrate according to an embodiment of the disclosure;
FIG. 9 is a cross-sectional view illustrating a circuit board assembly according to an embodiment of the disclosure;
FIG. 10 is an enlarged view illustrating portion B of FIG. 9 according to an embodiment of the disclosure;
FIGS. 11A, 11B, 11C, 11D, and 11E are views illustrating a manufacturing process of a circuit board assembly according to an embodiment of the disclosure;
FIG. 12 is a plan view illustrating a first substrate according to an embodiment of the disclosure;
FIG. 13 is a plan view illustrating a first substrate according to an embodiment of the disclosure;
FIG. 14 is a cross-sectional view illustrating a circuit board assembly according to an embodiment of the disclosure;
FIG. 15 is an enlarged view of portion C of FIG. 14 according to an embodiment of the disclosure;
FIG. 16 is a cross-sectional view illustrating a circuit board assembly according to an embodiment of the disclosure; and
FIG. 17 is an enlarged view of portion D of FIG. 16 according to an embodiment of the disclosure.

### [Mode for Carrying out the Invention]

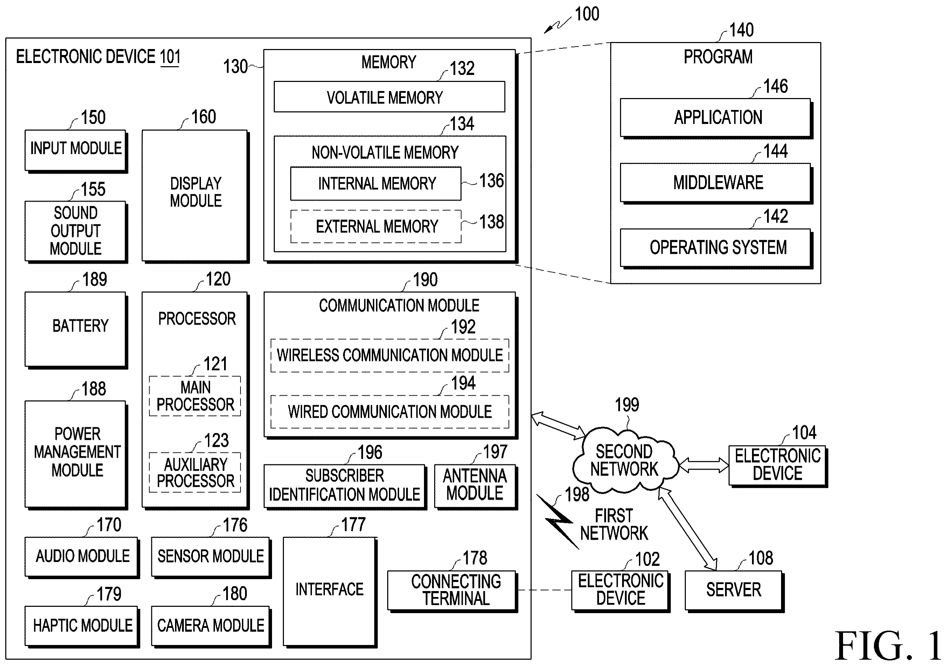

FIG. 1 is a block diagram illustrating an electronic device 101 in a network environment 100 according to various embodiments.

Referring to FIG. 1, the electronic device 101 in the network environment 100 may communicate with at least one of an electronic device 102 via a first network 198 (e.g., a short-range wireless communication network), or an electronic device 104 or a server 108 via a second network 199 (e.g., a long-range wireless communication network). According to an embodiment, the electronic device 101 may communicate with the electronic device 104 via the server 108. According to an embodiment, the electronic device 101 may include a processor 120, memory 130, an input module 150, a sound output module 155, a display module 160, an audio module 170, a sensor module 176, an interface 177, a connecting terminal 178, a haptic module 179, a camera module 180, a power management module 188, a battery 189, a communication module 190, a subscriber identification module (SIM) 196, or an antenna module 197. In an embodiment, at least one (e.g., the connecting terminal 178) of the components may be omitted from the electronic device 101, or one or more other components may be added in the electronic device 101. According to an embodiment, some (e.g., the sensor module 176, the camera module 180, or the antenna module 197) of the components may be integrated into a single component (e.g., the display module 160).

The processor 120 may execute, for example, software (e.g., a program 140) to control at least one other component (e.g., a hardware or software component) of the electronic device 101 coupled with the processor 120, and may perform various data processing or computation. According to an embodiment, as at least part of the data processing or computation, the processor 120 may store a command or data received from another component (e.g., the sensor module 176 or the communication module 190) in volatile memory 132, process the command or the data stored in the volatile memory 132, and store resulting data in non-volatile memory 134. According to an embodiment, the processor 120 may include a main processor 121 (e.g., a central processing unit (CPU) or an application processor (AP)), or an auxiliary processor 123 (e.g., a graphics processing unit (GPU), a neural processing unit (NPU), an image signal processor (ISP), a sensor hub processor, or a communication processor (CP)) that is operable independently from, or in conjunction with, the main processor 121. For example, when the electronic device 101 includes the main processor 121 and the sub processor 123, the sub processor 123 may be configured to use lower power than the main processor 121 or to be specified for a designated function. The sub processor 123 may be implemented as separate from, or as part of the main processor 121.

The auxiliary processor 123 may control at least some of functions or states related to at least one component (e.g., the display module 160, the sensor module 176, or the communication module 190) among the components of the electronic device 101, instead of the main processor 121 while the main processor 121 is in an inactive (e.g., sleep) state, or together with the main processor 121 while the main processor 121 is in an active state (e.g., executing an application). According to an embodiment, the auxiliary processor 123 (e.g., an image signal processor or a communication processor) may be implemented as part of another component (e.g., the camera module 180 or the communication module 190) functionally related to the auxiliary processor 123. According to an embodiment, the auxiliary processor 123 (e.g., the neural processing unit) may include a hardware structure specified for artificial intelligence model processing. The artificial intelligence model may be generated via machine learning. Such learning may be performed, e.g., by the electronic device 101 where the artificial intelligence is performed or via a separate server (e.g., the server 108). Learning algorithms may include, but are not limited to, e.g., supervised learning, unsupervised learning, semi-supervised learning, or reinforcement learning. The artificial intelligence model may include a plurality of artificial neural network layers. The artificial neural network may be a deep neural network (DNN), a convolutional neural network (CNN), a recurrent neural network (RNN), a restricted Boltzmann machine (RBM), a deep belief network (DBN), a bidirectional recurrent deep neural network (BRDNN), deep Q-network or a combination of two or more thereof but is not limited thereto. The artificial intelligence model may, additionally or alternatively, include a software structure other than the hardware structure.

The memory 130 may store various data used by at least one component (e.g., the processor 120 or the sensor module 176) of the electronic device 101. The various data may include, for example, software (e.g., the program 140) and input data or output data for a command related thereto. The memory 130 may include the volatile memory 132 or the non-volatile memory 134.

The program 140 may be stored in the memory 130 as software, and may include, for example, an operating system (OS) 142, middleware 144, or an application 146.

The input module 150 may receive a command or data to be used by other component (e.g., the processor 120) of the electronic device 101, from the outside (e.g., a user) of the electronic device 101. The input module 150 may include, for example, a microphone, a mouse, a keyboard, keys (e.g., buttons), or a digital pen (e.g., a stylus pen).

The sound output module 155 may output sound signals to the outside of the electronic device 101. The sound output module 155 may include, for example, a speaker or a receiver. The speaker may be used for general purposes, such as playing multimedia or playing record. The receiver may be used for receiving incoming calls. According to an embodiment, the receiver may be implemented as separate from, or as part of the speaker.

The display module 160 may visually provide information to the outside (e.g., a user) of the electronic device 101. The display 160 may include, for example, a display, a hologram device, or a projector and control circuitry to control a corresponding one of the display, hologram device, and projector. According to an embodiment, the display 160 may include a touch sensor configured to detect a touch, or a pressure sensor configured to measure the intensity of a force generated by the touch.

The audio module 170 may convert a sound into an electrical signal and vice versa. According to an embodiment, the audio module 170 may obtain the sound via the input module 150, or output the sound via the sound output module 155 or a headphone of an external electronic device (e.g., an electronic device 102) directly (e.g., wiredly) or wirelessly coupled with the electronic device 101.

The sensor module 176 may detect an operation state (e.g., power or temperature) of the electronic device 101 or an environmental state (e.g., a state of a user) external to the electronic device 101, and then generate an electrical signal or data value corresponding to the detected state. According to an embodiment, the sensor module 176 may include, for example, a gesture sensor, a gyro sensor, an atmospheric pressure sensor, a magnetic sensor, an accelerometer, a grip sensor, a proximity sensor, a color sensor, an infrared (IR) sensor, a biometric sensor, a temperature sensor, a humidity sensor, or an illuminance sensor.

The interface 177 may support one or more specified protocols to be used for the electronic device 101 to be coupled with the external electronic device (e.g., the electronic device 102) directly (e.g., wiredly) or wirelessly. According to an embodiment, the interface 177 may include, for example, a high definition multimedia interface (HDMI), a universal serial bus (USB) interface, a secure digital (SD) card interface, or an audio interface.

A connecting terminal 178 may include a connector via which the electronic device 101 may be physically connected with the external electronic device (e.g., the electronic device 102). According to an embodiment, the connecting terminal 178 may include, for example, an HDMI connector, a USB connector, an SD card connector, or an audio connector (e.g., a headphone connector).

The haptic module 179 may convert an electrical signal into a mechanical stimulus (e.g., a vibration or motion) or electrical stimulus which may be recognized by a user via his tactile sensation or kinesthetic sensation. According to an embodiment, the haptic module 179 may include, for example, a motor, a piezoelectric element, or an electric stimulator.

The camera module 180 may capture a still image or moving images. According to an embodiment, the camera module 180 may include one or more lenses, image sensors, image signal processors, or flashes.

The power management module 188 may manage power supplied to the electronic device 101. According to an embodiment, the power management module 188 may be implemented as at least part of, for example, a power management integrated circuit (PMIC).

The battery 189 may supply power to at least one component of the electronic device 101. According to an embodiment, the battery 189 may include, for example, a primary cell which is not rechargeable, a secondary cell which is rechargeable, or a fuel cell.

The communication module 190 may support establishing a direct (e.g., wired) communication channel or a wireless communication channel between the electronic device 101 and the external electronic device (e.g., the electronic device 102, the electronic device 104, or the server 108) and performing communication via the established communication channel. The communication module 190 may include one or more communication processors that are operable independently from the processor 120 (e.g., the application processor (AP)) and supports a direct (e.g., wired) communication or a wireless communication. According to an embodiment, the communication module 190 may include a wireless communication module 192 (e.g., a cellular communication module, a short-range wireless communication module, or a global navigation satellite system (GNSS) communication module) or a wired communication module 194 (e.g., a local area network (LAN) communication module or a power line communication (PLC) module). A corresponding one of these communication modules may communicate with the external electronic device 104 via a first network 198 (e.g., a short-range communication network, such as Bluetooth^{™}, wireless-fidelity (Wi-Fi) direct, or infrared data association (IrDA)) or a second network 199 (e.g., a long-range communication network, such as a legacy cellular network, a 5G network, a next-generation communication network, the Internet, or a computer network (e.g., local area network (LAN) or wide area network (WAN)). These various types of communication modules may be implemented as a single component (e.g., a single chip), or may be implemented as multi components (e.g., multi chips) separate from each other. The wireless communication module 192 may identify or authenticate the electronic device 101 in a communication network, such as the first network 198 or the second network 199, using subscriber information (e.g., international mobile subscriber identity (IMSI)) stored in the subscriber identification module 196.

The wireless communication module 192 may support a 5G network, after a 4G network, and next-generation communication technology, e.g., new radio (NR) access technology. The NR access technology may support enhanced mobile broadband (eMBB), massive machine type communications (mMTC), or ultra-reliable and low-latency communications (URLLC). The wireless communication module 192 may support a high-frequency band (e.g., the mmWave band) to achieve, e.g., a high data transmission rate. The wireless communication module 192 may support various technologies for securing performance on a high-frequency band, such as, e.g., beamforming, massive multiple-input and multiple-output (massive MIMO), full dimensional MIMO (FD-MIMO), array antenna, analog beam-forming, or large scale antenna. The wireless communication module 192 may support various requirements specified in the electronic device 101, an external electronic device (e.g., the electronic device 104), or a network system (e.g., the second network 199). According to an embodiment, the wireless communication module 192 may support a peak data rate (e.g., 20Gbps or more) for implementing eMBB, loss coverage (e.g., 164dB or less) for implementing mMTC, or U-plane latency (e.g., 0.5ms or less for each of downlink (DL) and uplink (UL), or a round trip of 1ms or less) for implementing URLLC.

The antenna module 197 may transmit or receive a signal or power to or from the outside (e.g., the external electronic device). According to an embodiment, the antenna module 197 may include one antenna including a radiator formed of a conductor or conductive pattern formed on a substrate (e.g., a printed circuit board (PCB)). According to an embodiment, the antenna module 197 may include a plurality of antennas (e.g., an antenna array). In this case, at least one antenna appropriate for a communication scheme used in a communication network, such as the first network 198 or the second network 199, may be selected from the plurality of antennas by, e.g., the communication module 190. The signal or the power may then be transmitted or received between the communication module 190 and the external electronic device via the selected at least one antenna. According to an embodiment, other parts (e.g., radio frequency integrated circuit (RFIC)) than the radiator may be further formed as part of the antenna module 197.

According to various embodiments, the antenna module 197 may form a mmWave antenna module. According to an embodiment, the mmWave antenna module may include a printed circuit board, a RFIC disposed on a first surface (e.g., the bottom surface) of the printed circuit board, or adjacent to the first surface and capable of supporting a designated high-frequency band (e.g., the mmWave band), and a plurality of antennas (e.g., array antennas) disposed on a second surface (e.g., the top or a side surface) of the printed circuit board, or adjacent to the second surface and capable of transmitting or receiving signals of the designated high-frequency band.

At least some of the above-described components may be coupled mutually and communicate signals (e.g., commands or data) therebetween via an inter-peripheral communication scheme (e.g., a bus, general purpose input and output (GPIO), serial peripheral interface (SPI), or mobile industry processor interface (MIPI)).

According to an embodiment, commands or data may be transmitted or received between the electronic device 101 and the external electronic device 104 via the server 108 coupled with the second network 199. The external electronic devices 102 or 104 each may be a device of the same or a different type from the electronic device 101. According to an embodiment, all or some of operations to be executed at the electronic device 101 may be executed at one or more of the external electronic devices 102, 104, or 108. For example, if the electronic device 101 should perform a function or a service automatically, or in response to a request from a user or another device, the electronic device 101, instead of, or in addition to, executing the function or the service, may request the one or more external electronic devices to perform at least part of the function or the service. The one or more external electronic devices receiving the request may perform the at least part of the function or the service requested, or an additional function or an additional service related to the request, and transfer an outcome of the performing to the electronic device 101. The electronic device 101 may provide the outcome, with or without further processing of the outcome, as at least part of a reply to the request. To that end, a cloud computing, distributed computing, mobile edge computing (MEC), or client-server computing technology may be used, for example. The electronic device 101 may provide ultra low-latency services using, e.g., distributed computing or mobile edge computing. In another embodiment, the external electronic device 104 may include an Internet-of-things (IoT) device. The server 108 may be an intelligent server using machine learning and/or a neural network. According to an embodiment, the external electronic device 104 or the server 108 may be included in the second network 199. The electronic device 101 may be applied to intelligent services (e.g., smart home, smart city, smart car, or healthcare) based on 5G communication technology or IoT-related technology.

The electronic device according to various embodiments of the disclosure may be one of various types of electronic devices. The electronic devices may include, for example, a portable communication device (e.g., a smartphone), a computer device, a portable multimedia device, a portable medical device, a camera, a wearable device, or a home appliance. According to an embodiment of the disclosure, the electronic devices are not limited to those described above.

It should be appreciated that various embodiments of the present disclosure and the terms used therein are not intended to limit the technological features set forth herein to particular embodiments and include various changes, equivalents, or replacements for a corresponding embodiment. With regard to the description of the drawings, similar reference numerals may be used to refer to similar or related elements. It is to be understood that a singular form of a noun corresponding to an item may include one or more of the things, unless the relevant context clearly indicates otherwise. As used herein, each of such phrases as "A or B," "at least one of A and B," "at least one of A or B," "A, B, or C," "at least one of A, B, and C," and "at least one of A, B, or C," may include all possible combinations of the items enumerated together in a corresponding one of the phrases. As used herein, such terms as "1st" and "2nd," or "first" and "second" may be used to simply distinguish a corresponding component from another, and does not limit the components in other aspect (e.g., importance or order). It is to be understood that if an element (e.g., a first element) is referred to, with or without the term "operatively" or "communicatively", as "coupled with," "coupled to," "connected with," or "connected to" another element (e.g., a second element), it means that the element may be coupled with the other element directly (e.g., wiredly), wirelessly, or via a third element.

As used herein, the term "module" may include a unit implemented in hardware, software, or firmware, and may interchangeably be used with other terms, for example, "logic," "logic block," "part," or "circuitry". A module may be a single integral component, or a minimum unit or part thereof, adapted to perform one or more functions. For example, according to an embodiment, the module may be implemented in a form of an application-specific integrated circuit (ASIC).

Various embodiments as set forth herein may be implemented as software (e.g., the program 140) including one or more instructions that are stored in a storage medium (e.g., internal memory 136 or external memory 138) that is readable by a machine (e.g., the electronic device 101). For example, a processor (e.g., the processor 120) of the machine (e.g., the electronic device 101) may invoke at least one of the one or more instructions stored in the storage medium, and execute it, with or without using one or more other components under the control of the processor. This allows the machine to be operated to perform at least one function according to the at least one instruction invoked. The one or more instructions may include a code generated by a complier or a code executable by an interpreter. The storage medium readable by the machine may be provided in the form of a non-transitory storage medium. Wherein, the term "non-transitory" simply means that the storage medium is a tangible device, and does not include a signal (e.g., an electromagnetic wave), but this term does not differentiate between where data is semi-permanently stored in the storage medium and where the data is temporarily stored in the storage medium.

According to an embodiment, a method according to various embodiments of the disclosure may be included and provided in a computer program product. The computer program products may be traded as commodities between sellers and buyers. The computer program product may be distributed in the form of a machine-readable storage medium (e.g., compact disc read only memory (CD-ROM)), or be distributed (e.g., downloaded or uploaded) online via an application store (e.g., Play Store^{™}), or between two user devices (e.g., smart phones) directly. If distributed online, at least part of the computer program product may be temporarily generated or at least temporarily stored in the machine-readable storage medium, such as memory of the manufacturer's server, a server of the application store, or a relay server.

According to various embodiments, each component (e.g., a module or a program) of the above-described components may include a single entity or multiple entities. Some of the plurality of entities may be separately disposed in different components. According to various embodiments, one or more of the above-described components may be omitted, or one or more other components may be added. Alternatively or additionally, a plurality of components (e.g., modules or programs) may be integrated into a single component. In such a case, according to various embodiments, the integrated component may still perform one or more functions of each of the plurality of components in the same or similar manner as they are performed by a corresponding one of the plurality of components before the integration. According to various embodiments, operations performed by the module, the program, or another component may be carried out sequentially, in parallel, repeatedly, or heuristically, or one or more of the operations may be executed in a different order or omitted, or one or more other operations may be added.

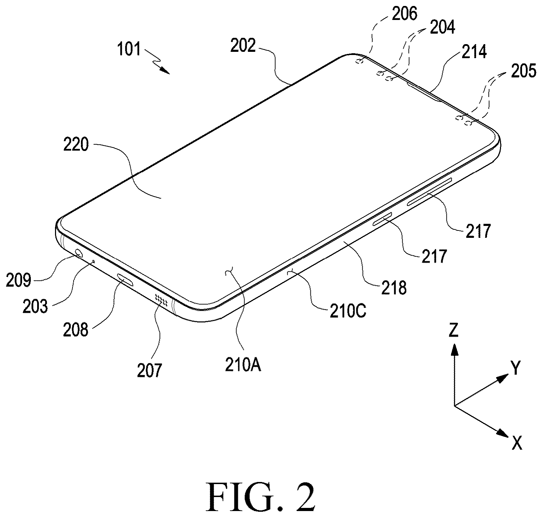

FIG. 2 is a front perspective view illustrating an electronic device according to an embodiment of the disclosure.

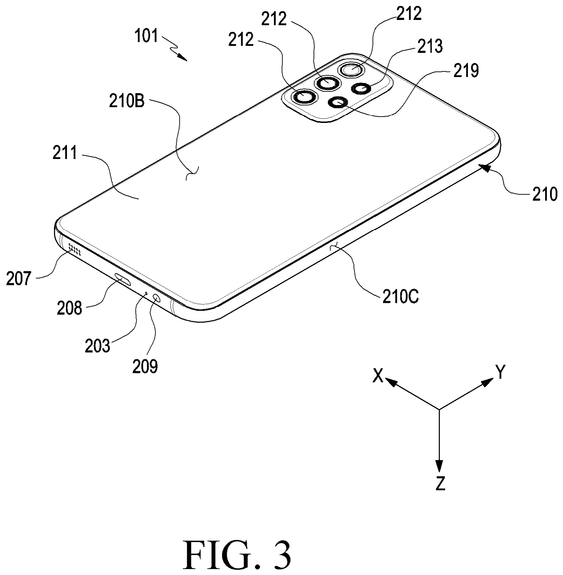

FIG. 3 is a rear perspective view illustrating an electronic device according to an embodiment of the disclosure.

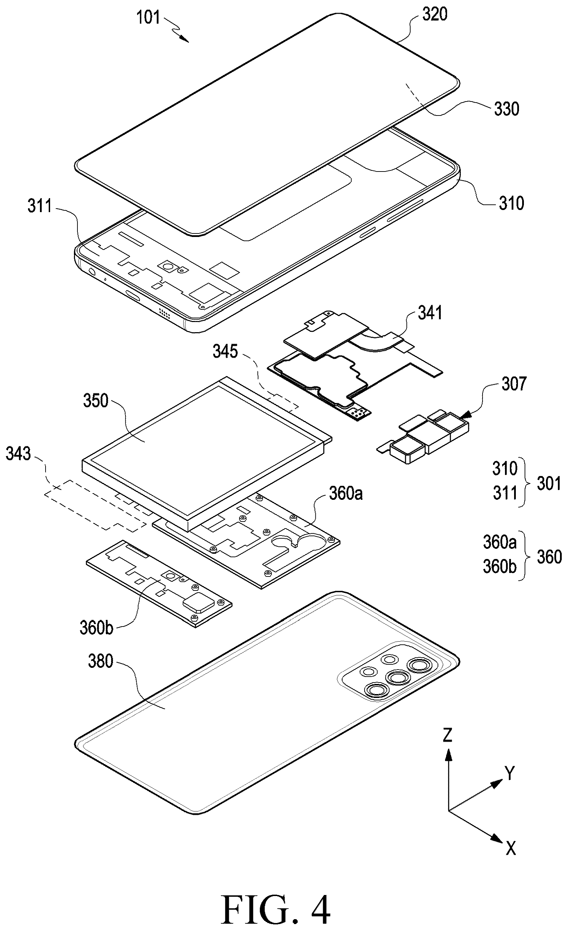

The embodiments of FIGS. 2 and 3 may be combined with the embodiment of FIG. 1 or the embodiments of FIGS. 4 to 17.

Referring to FIGS. 2 and 3, according to an embodiment, an electronic device 101 (e.g., the electronic device 101 of FIG. 1) may include a housing 210 including a first surface (or front surface) 210A, a second surface (or rear surface) 210B, and a side surface 210C surrounding a space between the first surface 210A and the second surface 210B. According to an embodiment (not illustrated), the housing 210 may denote a structure forming the first surface 210A of FIG. 2, the second surface 210B of FIG. 3, and some of the side surfaces 210C. According to an embodiment, at least part of the first surface 210A may have a substantially transparent front plate 202 (e.g., a glass plate or polymer plate including various coat layers). The second surface 210B may be formed by a rear plate 211 that is substantially opaque. The rear plate 211 may be formed of, e.g., laminated or colored glass, ceramic, polymer, metal (e.g., aluminum, stainless steel (STS), or magnesium), or a combination of at least two thereof. The side surface 210C may be formed by a side structure (or "side bezel structure") 218 that couples to the front plate 202 and the rear plate 211 and includes a metal and/or polymer. In an embodiment, the rear plate 211 and the side structure 218 may be integrally formed together and include the same material (e.g., a metal, such as aluminum).

Although not shown, the front plate 202 may include area(s) that bend from at least a portion of an edge toward the rear plate 211 and seamlessly extend. In an embodiment, only one of the areas of the front plate 202 (or the rear plate 211), which bend to the rear plate 211 (or front plate 202) and extend may be included in one edge of the first surface 210A. According to an embodiment, the front plate 202 or the rear plate 211 may have a substantially flat plate shape. For example, no bent and extended area may be included. When an area bending and extending is included, the thickness of the electronic device 101 at the portion including the area bending and extending may be smaller than the thickness of the rest.

According to an embodiment, the electronic device 101 may include at least one or more of a display 220, audio modules 203, 207, and 214, sensor modules 204 and 219, camera modules 205, 212, and 213, key input devices 217, a light emitting device 206, and connector holes 208 and 209. In an embodiment, the electronic device 101 may exclude at least one (e.g., the key input device 217 or the light emitting device 206) of the components or may add other components.

The display 220 may be visually exposed through a significant portion of the front plate 202. In an embodiment, at least a portion of the display 220 may be visually exposed through the front plate 202 forming the first surface 210A, or through a portion of the side surface 210C. In an embodiment, the edge of the display 220 may be formed to be substantially the same in shape as an adjacent outer edge of the front plate 202. In an embodiment (not illustrated), the interval between the outer edge of the display 220 and the outer edge of the front plate 202 may remain substantially even to give a larger area of visual exposure of the display 220.

In an embodiment (not shown), the screen display region of the display 220 may have a recess or opening in a portion thereof, and at least one or more of the audio module 214, sensor module 204, camera module 205, and light emitting device 206 may be aligned with the recess or opening. In an embodiment (not shown), at least one or more of the audio module 214, sensor module 204, camera module 205, fingerprint sensor (not shown), and light emitting device 206 may be included on the rear surface of the screen display area of the display 220. In an embodiment (not illustrated), the display 220 may be disposed to be coupled with, or adjacent, a touch detecting circuit, a pressure sensor capable of measuring the strength (pressure) of touches, and/or a digitizer for detecting a magnetic field-type stylus pen. In an embodiment, at least part of the sensor modules 204 and 219 and/or at least part of the key input devices 217 may be disposed in the first regions 210D and/or the second regions 210E.

The audio modules 203, 207, and 214 may include a microphone hole 203 and speaker holes 207 and 214. A microphone for acquiring external sounds may be disposed in the microphone hole 203. In an embodiment, a plurality of microphones may be disposed to detect the direction of the sound. The speaker holes 207 and 214 may include an external speaker hole 207 and a phone receiver hole 214. In an embodiment, the speaker holes 207 and 214 and the microphone hole 203 may be implemented as a single hole, or speakers may be rested without the speaker holes 207 and 214 (e.g., piezo speakers).

The sensor modules 204 and 219 may generate an electrical signal or data value corresponding to an internal operating state or external environmental state of the electronic device 101. For example, the sensor modules 204 and 219 may include a first sensor module 204 (e.g., a proximity sensor) and/or a second sensor module (not shown) (e.g., a fingerprint sensor), which is disposed on the first surface 210A of the housing 210, and/or a third sensor module 219 and/or a fourth sensor module (e.g., a fingerprint sensor) disposed on the second surface 210B of the housing 210. The fingerprint sensor may be disposed on the second surface 210B or side surface 210C as well as the first surface 210A (e.g., the display 220) of the housing 210. The electronic device 101 may further include, e.g., at least one of a gesture sensor, a gyro sensor, an atmospheric pressure sensor, a magnetic sensor, an acceleration sensor, a grip sensor, a color sensor, an infrared (IR) sensor, a biometric sensor, a temperature sensor, a humidity sensor, or an illuminance sensor.

The camera modules 205, 212, and 213 may include a first camera device 205 disposed on the first surface 210A of the electronic device 101, and a second camera device 212 and/or a flash 213 disposed on the second surface 210B. The camera devices 205 and 212 may include one or more lenses, an image sensor, and/or an image signal processor. The flash 213 may include, e.g., a light emitting diode (LED) or a xenon lamp. In an embodiment, two or more lenses (infrared cameras, wide-angle and telephoto lenses) and image sensors may be disposed on one surface of the electronic device 101. In an embodiment, flash 213 may emit infrared light. The infrared light emitted by the flash 213 and reflected by the subject may be received through the third sensor module 219. The electronic device 101 or the processor of the electronic device 101 may detect depth information about the subject based on the time point when the infrared light is received from the third sensor module 219.

The key input device 217 may be disposed on the side surface 210C of the housing 210. In an embodiment, the electronic device 101 may exclude all or some of the above-mentioned key input devices 217 and the excluded key input devices 217 may be implemented in other forms, e.g., as soft keys, on the display 220. In an embodiment, the key input device may include the sensor module disposed on the second surface 210B of the housing 210.

The light emitting device 206 may be disposed on, e.g., the first surface 210A of the housing 210. The light emitting device 206 may provide, e.g., information about the state of the electronic device 101 in the form of light. In an embodiment, the light emitting device 206 may provide a light source that interacts with, e.g., the camera module 205. The light emitting device 206 may include, e.g., an light emitting diode (LED), an infrared (IR) LED, or a xenon lamp.

The connector holes 208 and 209 may include a first connector hole 208 for receiving a connector (e.g., a universal serial bus (USB) connector) for transmitting or receiving power and/or data to/from an external electronic device and/or a second connector hole 209 (e.g., an earphone jack) for receiving a connector for transmitting or receiving audio signals to/from the external electronic device.

FIG. 4 is a front exploded perspective view illustrating an electronic device according to an embodiment of the disclosure.

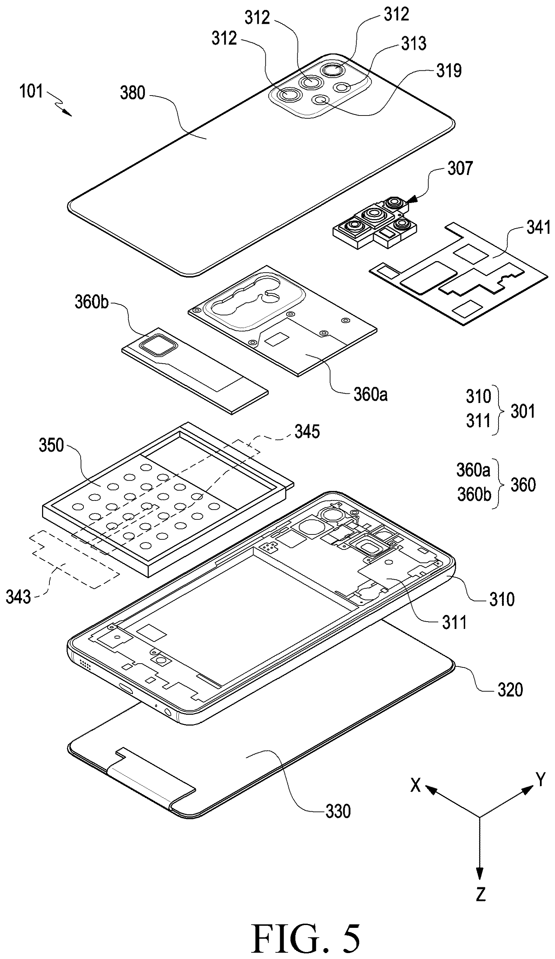

FIG. 5 is a rear exploded perspective view illustrating an electronic device according to an embodiment of the disclosure.

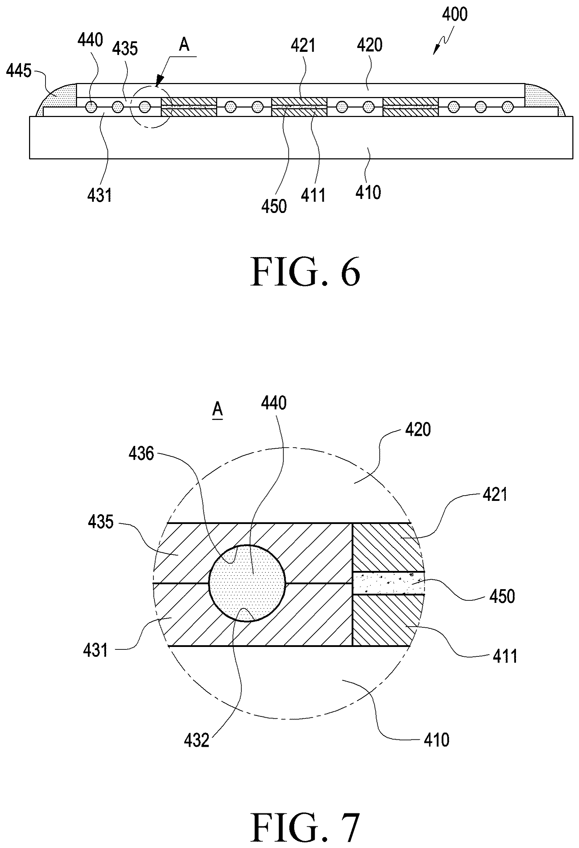

The embodiments of FIGS. 4 and 5 may be combined with the embodiments of FIGS. 1 and 3 or the embodiments of FIGS. 6 to 17.

Referring to FIGS. 3 and 4, an electronic device 101 (e.g., the electronic device 101 of FIG. 1 or FIG. 2) may include a side structure 310, a first supporting member 311 (e.g., a bracket), a front plate 320 (e.g., the front plate 202 of FIG. 1), a display 330 (e.g., the display 220 of FIG. 1), at least one printed circuit board (or a board assembly) 341, 343, a battery 350, a second supporting member 360 (e.g., a rear case), an antenna, a camera assembly 307, and a rear plate 380 (e.g., the rear plate 211 of FIG. 2). When the plurality of printed circuit boards 341, 343 are included, the electronic device 101 may include at least one flexible printed circuit board 345 to electrically connect different printed circuit boards. For example, the printed circuit boards 341 and 343 may include a first circuit board 341 disposed above the battery 350 (e.g., in the +Y-axis direction) and a second circuit board 343 disposed under the battery 350 (e.g., in the -Y-axis direction), and the flexible printed circuit board 345 may electrically connect the first circuit board 341 and the second circuit board 343.

According to an embodiment, the electronic device 101 may exclude at least one (e.g., the first supporting member 311 or the second supporting member 360) of the components or may add other components. At least one of the components of the electronic device 101 may be the same or similar to at least one of the components of the electronic device 101 of FIG. 1 to 3 and no duplicate description is made below.

According to an embodiment, at least a portion of the first supporting member 311 may be provided in a flat plate shape. In an embodiment, the first supporting member 311 may be disposed inside the electronic device 101 to be connected with the side structure 310 or integrated with the side structure 310. The first supporting member 311 may be formed of, e.g., a metallic material and/or non-metallic material (e.g., polymer). When the first supporting member 311 is at least partially formed of a metallic material, a portion of the side structure 310 or the first supporting member 311 may function as an antenna. The display 330 may be joined onto one surface of the first supporting member 311, and the printed circuit boards 341 and 343 may be joined onto the opposite surface of the first supporting member 311. A processor, memory, and/or interface may be mounted on the printed circuit boards 341 and 343. The processor may include one or more of, e.g., a central processing unit, an application processor, a graphic processing device, an image signal processing, a sensor hub processor, or a communication processor.

According to an embodiment, the first supporting member 311 and the side structure 310 may be collectively referred to as a front case or a housing 301. According to an embodiment, the housing 301 may be generally understood as a structure for receiving, protecting, or disposing the printed circuit boards 341 and 343 or the battery 350. In an embodiment, the housing 301 may be understood as including a structure that the user may visually or tactfully recognize from the outside of the electronic device 101, e.g., the side structure 310, the front plate 320, and/or the rear plate 380. In an embodiment, the 'front or rear surface of the housing 301' may refer to the first surface 210A of FIG. 2 or the second surface 210B of FIG. 3. In an embodiment, the first supporting member 311 may be disposed between the front plate 320 (e.g., the first surface 210A of FIG. 2) and the rear plate 380 (e.g., the second surface 210B of FIG. 3) and may function as a structure for placing an electrical/electronic component, such as the printed circuit boards 341 and 343 or the camera assembly 307.

According to an embodiment, the memory may include, e.g., a volatile or non-volatile memory.

According to an embodiment, the interface may include, e.g., a high definition multimedia interface (HDMI), a universal serial bus (USB) interface, a secure digital (SD) card interface, and/or an audio interface. The interface may electrically or physically connect, e.g., the electronic device 101 with an external electronic device and may include a USB connector, an SD card/multimedia card (MMC) connector, or an audio connector.

According to an embodiment, the second supporting member 360 may include, e.g., an upper supporting member 360a and a lower supporting member 360b. In an embodiment, the upper supporting member 360a, together with a portion of the first supporting member 311, may be disposed to surround the printed circuit boards 341 and 343 (e.g., the first circuit board 341). For example, the upper supporting member 360a of the second supporting member 360 may be disposed to face the first supporting member 311 with the first circuit board 341 interposed therebetween. In an embodiment, the lower supporting member 360b of the second supporting member 360 may be disposed to face the first supporting member 311 with the second circuit board 343 interposed therebetween. A circuit device (e.g., a processor, a communication module, or memory) implemented in the form of an integrated circuit chip or various electrical/electronic components may be disposed on the printed circuit boards 341 and 343. According to an embodiment, the printed circuit boards 341 and 343 may receive an electromagnetic shielding environment from the second supporting member 360. In an embodiment, the lower supporting member 360b may be utilized as a structure in which electrical/electronic components, such as a speaker module and an interface (e.g., a USB connector, an SD card/MMC connector, or an audio connector) may be disposed. In an embodiment, electrical/electronic components, such as a speaker module and an interface (e.g., a USB connector, an SD card/MMC connector, or an audio connector) may be disposed on an additional printed circuit board (not shown). For example, the lower supporting member 360b, together with the other part of the first supporting member 311, may be disposed to surround the additional printed circuit board. The speaker module or interface disposed on the additional printed circuit board (not shown) or the lower supporting member 360b may be disposed corresponding to the audio module 207 or connector holes 208 and 209 of FIG. 2.

According to an embodiment, the battery 350 may be a device for supplying power to at least one component of the electronic device 101. The battery 189 may include, e.g., a primary cell which is not rechargeable, a secondary cell which is rechargeable, or a fuel cell. At least a portion of the battery 350 may be disposed on substantially the same plane as the printed circuit boards 341 and 343. The battery 350 may be integrally or detachably disposed inside the electronic device 101.

Although not shown, the antenna may include a conductor pattern implemented on the surface of the second supporting member 360 through, e.g., laser direct structuring. In an embodiment, the antenna may include a printed circuit pattern formed on the surface of the thin film. The thin film-type antenna may be disposed between the rear plate 380 and the battery 350. The antenna may include, e.g., a near-field communication (NFC) antenna, a wireless charging antenna, and/or a magnetic secure transmission (MST) antenna. The antenna may perform short-range communication with, e.g., an external device or may wirelessly transmit or receive power necessary for charging. In an embodiment of the present invention, another antenna structure may be formed by a portion or combination of the side structure 310 and/or the first supporting member 311.

According to an embodiment, the camera assembly 307 may include at least one camera module. Inside the electronic device 101, the camera assembly 307 (or at least one camera module) may receive at least a portion of the light incident through the optical hole or the camera windows 312, 313, and 319. In an embodiment, the camera assembly 307 may be disposed on the first supporting member 311 in a position adjacent to the printed circuit boards 341 and 343. In an embodiment, the camera module(s) of the camera assembly 307 may be generally aligned with either one of the camera windows 312, 313, and 319 and be a least partially surrounded by the second supporting member 360 (e.g., the upper supporting member 360a).

FIG. 6 is a cross-sectional view illustrating a circuit board assembly according to an embodiment of the disclosure.

FIG. 7 is an enlarged view of part A of FIG. 6 according to an embodiment of the disclosure.

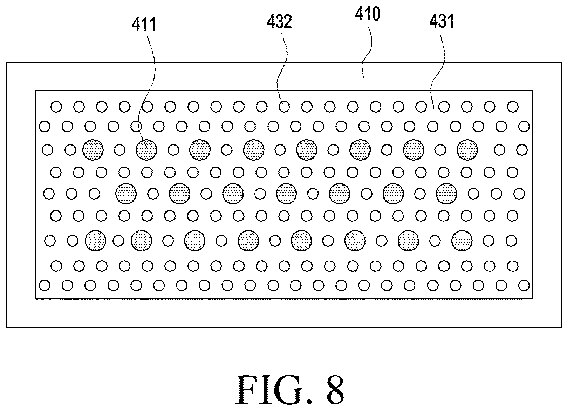

The embodiments of FIGS. 6 and 7 may be combined with the embodiments of FIGS. 1 and 5 or the embodiments of FIGS. 8 to 17.

Referring to FIGS. 6 to 7, the circuit board assembly 400 may include a first substrate 410, an electrical component 420, a first layer 431, a second layer 435, a first bonding resin 440, or a conductive member 450.

The configuration of the first circuit board 410 of FIGS. 6 to 7 may be partially or entirely identical to the configuration of the first circuit board 341 of FIGS. 4 to 5.

According to an embodiment, the circuit board assembly 400 may be disposed inside an electronic device (e.g., the electronic device 101 of FIGS. 1 to 5). For example, the circuit board assembly 400 may be disposed inside a housing of the electronic device (e.g., the housing 210 of FIGS. 2 to 3, or the housing 301 of FIGS. 4 to 5).

According to an embodiment, the first substrate 410 may be a printed circuit board (PCB). For example, the first substrate 410 may be a substrate formed of ceramic, polyimide (PI), polyethylene terephthalate (PET), or glass material, but the disclosure is not limited thereto.

According to an embodiment, the first substrate 410 may include at least one first pad 411. For example, the at least one first pad 411 of the first substrate 410 may be electrically connected to at least one second pad 421 of the electrical component 420. According to an embodiment, the at least one first pad 411 may be electrically connected to a thin film transistor disposed inside the first substrate 410.

According to an embodiment, the at least one first pad 411 may include a conductive material.

According to an embodiment, the electrical component 420 may include at least one second pad 421 for electrical connection to the first substrate 410. For example, the at least one second pad 421 of the electrical component 420 may be positioned corresponding to the at least one first pad 411.

According to an embodiment, the electrical component 420 may include a printed circuit board (PCB), a flexible printed circuit board (FPCB), a microchip, a passive element, or a molding compound configured to transmit/receive electrical signals with the first substrate 410. For example, the electrical component 420 may be a polyimide (PI), urethane, or silicon (Si) based printed circuit board, a flexible printed circuit board, a microchip, a passive element, or a molding compound, but the disclosure is not limited thereto.

According to an embodiment, the at least one second pad 421 may be electrically connected to the at least one first pad 411. Further, the at least one second pad 421 may be electrically connected to a thin film transistor disposed inside the electrical component 420.

According to an embodiment, the at least one second pad 421 may include a conductive material.

According to an embodiment, the first substrate 410 and the electrical component 420 may be electrically connected through the at least one first pad 411 and the at least one second pad 421. For example, the first substrate 410 and the electrical component 420 may be configured to transmit/receive electrical signals with each other.

According to an embodiment, the first layer 431 may be disposed on the first substrate 410. For example, the first layer 431 may be stacked on one surface of the first substrate 410 (e.g., a surface facing the electrical component 420).

According to an embodiment, the first layer 431 may be a solder resist layer that protects one surface of the first substrate 410. According to an embodiment, the first layer 431 may be a cover-lay layer or a solder mask layer that forms one surface of the first substrate 410.

According to an embodiment, the first layer 431 may include at least one first receiving portion 432. The at least one first receiving portion 432 may be defined as a groove or recess recessed from one surface of the first layer 431 (e.g., a surface facing the electrical component 420).

According to an embodiment, a maximum depth of the at least one first receiving portion 432 may be defined or referred to as a maximum height of the at least one first receiving portion 432.

According to an embodiment, the first layer 431 may surround the at least one first pad 411. Further, the first layer 431 may contact or connect with the at least one first pad 411 (e.g., a side surface of the at least one first pad 411).

According to an embodiment, the second layer 435 may be disposed on the electrical component 420. For example, the second layer 435 may be stacked on one surface of the electrical component 420 (e.g., a surface facing the first substrate 410).

According to an embodiment, the second layer 435 may be a solder resist layer that protects one surface of the electrical component 420. According to an embodiment, the second layer 435 may be a cover-lay layer or a solder mask layer that forms one surface of the electrical component 420.

According to an embodiment, the second layer 435 may include at least one second receiving portion 436. The at least one second receiving portion 436 may be defined as a groove or recess recessed from one surface of the second layer 435 (e.g., a surface facing the first substrate 410).

According to an embodiment, a maximum depth of the at least one second receiving portion 436 may be defined or referred to as a maximum height of the at least one second receiving portion 436.

According to an embodiment, a sum of the maximum depth of the at least one first receiving portion 432 and the maximum depth of the at least one second receiving portion 436 may be smaller than a sum of the thickness of the first layer 431 and the thickness of the second layer 435.

According to an embodiment, the at least one second receiving portion 436 may be positioned corresponding to the at least one first receiving portion 432.

According to an embodiment, the second layer 435 may surround the at least one second pad 421. Further, the second layer 435 may contact or connect with the at least one second pad 421 (e.g., a side surface of the at least one second pad 421).

According to an embodiment, the second layer 435 may be stacked on the first layer 431. For example, the second layer 435 may tightly contact the first layer 431. According to an embodiment, the second layer 435 may be defined as being stacked or bonded to the first layer 431 through a thermal compressing process.

According to an embodiment, the at least one first receiving portion 432 and the at least one second receiving portion 436 may provide a receiving space for disposing the first bonding resin 440. A cross-sectional shape of the receiving space may be circular as in the illustrated embodiment, but the disclosure is not limited thereto. For example, the cross-sectional shape of the receiving space may have an elliptical, square, rhombic, rectangular, or various polygonal cross-sectional shape.

According to an embodiment, the first bonding resin 440 may be disposed in a space formed by the first receiving portion 432 and the second receiving portion 436 when the second layer 435 is stacked on the first layer 431.

According to an embodiment, the first bonding resin 440 may include at least one of an epoxy resin or an acrylic resin.

According to an embodiment, the first bonding resin 440 may enhance bonding strength between the first layer 431 and the second layer 435. For example, the first bonding resin 440 may enhance binding force between the first layer 431 and the second layer 435. Further, the first bonding resin 440 may mitigate impact directly applied to the first pad 411 or the second pad 421 when external impact is applied to the electronic device (or the circuit board assembly 400).

According to an embodiment, a second bonding resin 445 may be disposed on side surfaces of the first layer 431 and the second layer 435 when the second layer 435 is stacked on the first layer 431. For example, the second bonding resin 445 may cover side surfaces of the first layer 431 and the second layer 435.

According to an embodiment, the second bonding resin 445 may include at least one of an epoxy resin or an acrylic resin.

According to an embodiment, the second bonding resin 445 may block foreign objects (e.g., moisture) from entering between the first layer 431 and the second layer 435. For example, the second bonding resin 445 may block foreign objects from entering the first pad 411 and the second pad 421.

According to an embodiment, the second bonding resin 445 may be substantially the same material as the first bonding resin 440, but the disclosure is not limited thereto.

According to an embodiment, the first bonding resin 440 may be defined and/or referred to as an internal resin disposed inside the first layer 431 and the second layer 435, and the second bonding resin 445 may be defined and/or referred to as an external resin disposed outside the first layer 431 and the second layer 435.

According to an embodiment, the conductive member 450 may electrically connect the first pad 411 and the second pad 421. For example, the conductive member 450 may electrically connect the first pad 411 and the second pad 421. For example, the conductive member 450 may be formed through a solder ball, a stud bump, a pillar bump, or a metal paste. For example, the conductive member 450 may be soldered to the first pad 411 and the second pad 421.

According to an embodiment, between the first pad 411 and the second pad 422, the conductive member 450 may be disposed, and the first layer 431 and the second layer 435 may not be disposed.

According to an embodiment, the first receiving portion 432 (or the second receiving portion 436) may include a recessed groove or recess, and the second receiving portion 436 (or the first receiving portion 432) may include a through hole.

FIG. 8 is a plan view illustrating a first substrate according to an embodiment of the disclosure.

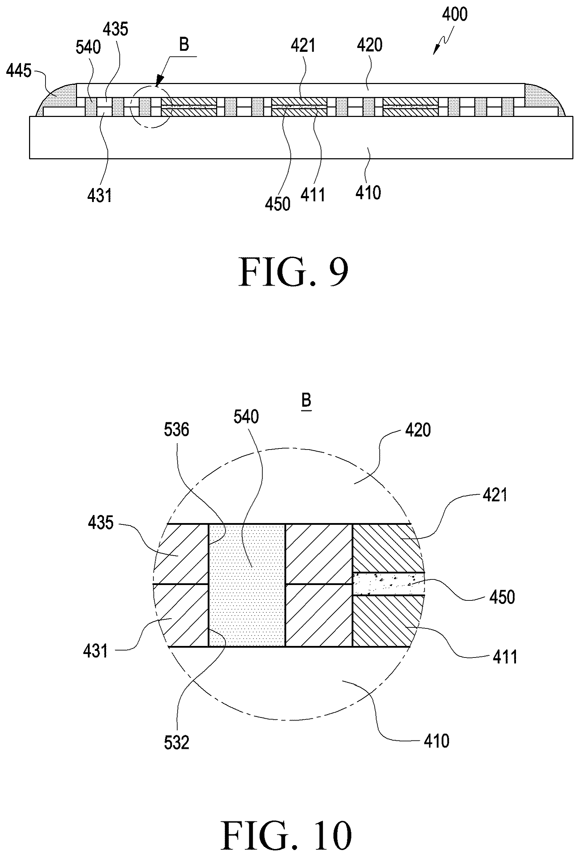

The embodiment of FIG. 8 may be combinable with the embodiments of FIGS. 1 to 7, or the embodiments of FIGS. 9 to 17.

Referring to FIG. 8, the first substrate 410 (e.g., the first substrate 410 of FIGS. 6 to 7) may include at least one first pad 411 (e.g., the at least one first pad 411 of FIGS. 6 to 7).

According to an embodiment, the first layer 431 (e.g., the first layer 431 of FIGS. 6 to 7) may be stacked on one surface of the first substrate 410.

According to an embodiment, the first layer 431 may include at least one first receiving portion 432 (e.g., the at least one first receiving portion 432 of FIGS. 6 to 7).

According to an embodiment, a cross-sectional shape of the at least one first receiving portion 432 (e.g., a cross-sectional shape of the at least one first receiving portion 432 when viewing the first substrate 410 from the electrical component 420 of FIGS. 6 to 7) may be circular, but is not limited thereto, and may have various shapes such as elliptical, rectangular, or polygonal shapes.

According to an embodiment, a cross-sectional shape of the at least one first pad 411 (e.g., a cross-sectional shape of the at least one first pad 411 when viewing the first substrate 410 from the electrical component 420 of FIGS. 6 to 7) may be circular, but is not limited thereto, and may have various shapes such as elliptical, rectangular, or polygonal shapes.

Although not illustrated, a cross-sectional shape of at least one second receiving portion (e.g., the at least one second receiving portion 436 of FIGS. 6 to 7) of a second layer (e.g., the second layer 435 of FIGS. 6 to 7) (e.g., a cross-sectional shape of the at least one second receiving portion 436 when viewing the electrical component 420 from the first substrate 410 of FIGS. 6 to 7) may be substantially the same as the cross-sectional shape of the at least one first receiving portion 432. Further, the at least one first receiving portion 432 may be positioned corresponding to the at least one second receiving portion 436.

Although not illustrated, a cross-sectional shape of at least one second pad (e.g., the at least one second pad 421 of FIGS. 6 to 7) of an electrical component (e.g., the electrical component 420 of FIGS. 6 to 7) (e.g., a cross-sectional shape of the at least one second pad 421 when viewing the electrical component 420 from the first substrate 410 of FIGS. 6 to 7) may be substantially the same as the cross-sectional shape of the at least one first pad 411. Further, the at least one first pad 411 may be positioned corresponding to the at least one second pad 421.

FIG. 9 is a cross-sectional view illustrating a circuit board assembly according to an embodiment of the disclosure.

FIG. 10 is an enlarged view illustrating portion B of FIG. 9 according to an embodiment of the disclosure.

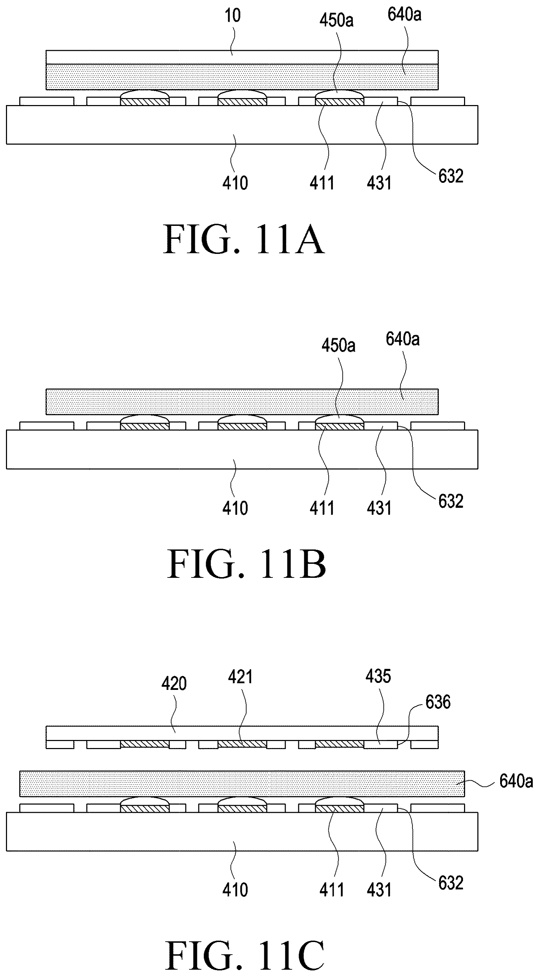

The embodiments of FIGS. 9 to 10 may be combined with the embodiments of FIGS. 1 to 8, or the embodiments of FIGS. 11A to 17.

The configurations of the circuit board assembly 400, the first circuit board 410, the at least one first pad 411, the electrical component 420, the at least one second pad 421, the first layer 431, the second layer 435, the first bonding resin 540, the second bonding resin 445, or the conductive member 450 of FIGS. 9 to 10 may be partially or entirely identical to the configurations of the circuit board assembly 400, the first circuit board 410, the at least one first pad 411, the electrical component 420, the at least one second pad 421, the first layer 431, the second layer 435, the first bonding resin 440, the second bonding resin 445, or the conductive member 450 of FIGS. 6 to 7.

The configurations of the first receiving portion 532 or the second receiving portion 536 of FIGS. 9 to 10 may be partially or entirely identical to the configurations of the first receiving portion 432 or the second receiving portion 436 of FIGS. 6 to 8.

According to an embodiment, the first layer 431 may include at least one first receiving portion 532. The at least one first receiving portion 532 may be defined as a hole penetrating from one surface of the first layer 431 (e.g., a surface facing the electrical component 420) to another surface (e.g., a surface facing the first substrate 410).

According to an embodiment, a maximum depth of the at least one first receiving portion 532 may be defined or referred to as a maximum height of the at least one first receiving portion 532.

According to an embodiment, the second layer 435 may include at least one second receiving portion 536. The at least one second receiving portion 536 may be defined as a hole penetrating from one surface of the second layer 435 (e.g., a surface facing the first substrate 410) to another surface (e.g., a surface facing the electrical component 420).

According to an embodiment, a maximum depth of the at least one second receiving portion 536 may be defined or referred to as a maximum height of the at least one second receiving portion 536.

According to an embodiment, a sum of the maximum depth of the at least one first receiving portion 532 and the maximum depth of the at least one second receiving portion 536 may be substantially identical to a sum of the thickness of the first layer 431 and the thickness of the second layer 435.

According to an embodiment, the at least one second receiving portion 536 may be positioned corresponding to the at least one first receiving portion 532.

According to an embodiment, the at least one first receiving portion 532 and the at least one second receiving portion 536 may provide a receiving space for disposing the first bonding resin 540. A cross-sectional shape of the receiving space may be rectangular as in the illustrated embodiment, but the disclosure is not limited thereto. For example, the cross-sectional shape of the receiving space may have a circular, elliptical, square, rhombic, rectangular, or various polygonal cross-sectional shape.

According to an embodiment, the first bonding resin 540 may be disposed in a space formed by the first receiving portion 532 and the second receiving portion 536 when the second layer 435 is stacked on the first layer 431.

According to an embodiment, the first bonding resin 540 may include at least one of an epoxy resin or an acrylic resin.

According to an embodiment, the first bonding resin 540 may enhance bonding strength between the first layer 431 and the second layer 435. For example, the first bonding resin 540 may enhance binding force between the first layer 431 and the second layer 435. Further, the first bonding resin 540 may mitigate impact directly applied to the first pad 411 or the second pad 421 when external impact is applied to the electronic device (or the circuit board assembly 400).

According to an embodiment, the first bonding resin 540 may be defined and/or referred to as an internal resin disposed inside the first layer 431 and the second layer 435, and the second bonding resin 445 may be defined and/or referred to as an external resin disposed outside the first layer 431 and the second layer 435.

According to an embodiment, the first receiving portion 532 (or the second receiving portion 536) may include a through hole, and the second receiving portion 536 (or the first receiving portion 532) may include a recessed groove or recess.

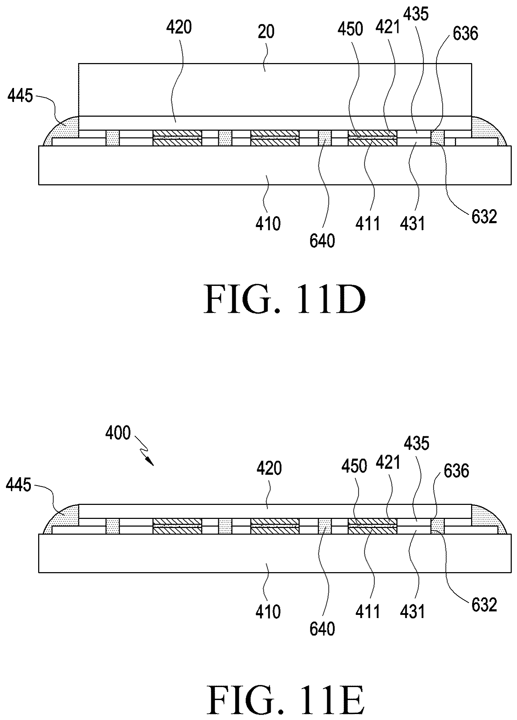

FIGS. 11A, 11B, 11C, 11D, and 11E are views illustrating a manufacturing process of a circuit board assembly according to an embodiment of the disclosure.

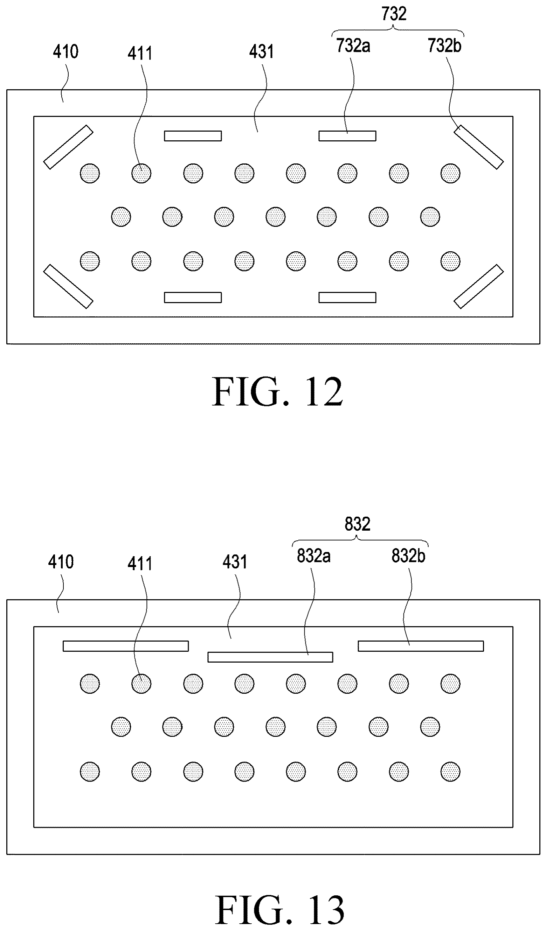

The embodiments of FIGS. 11A to 11E may be combinable with the embodiments of FIGS. 1 to 10, or the embodiments of FIGS. 12 to 17.

The configurations of the circuit board assembly 400, the first circuit board 410, the at least one first pad 411, the electrical component 420, the at least one second pad 421, the first layer 431, the second layer 435, the first bonding resin 640, the second bonding resin 445, or the conductive member 450 of FIGS. 11A to 11E may be partially or entirely identical to the configurations of the circuit board assembly 400, the first circuit board 410, the at least one first pad 411, the electrical component 420, the at least one second pad 421, the first layer 431, the second layer 435, the first bonding resin 440, 540, the second bonding resin 445, or the conductive member 450 of FIGS. 6 to 7 or FIGS. 9 to 10.

The configurations of the first receiving portion 632 or the second receiving portion 636 of FIGS. 11A to 11E may be partially or entirely identical to the configurations of the first receiving portion 432 or the second receiving portion 436 of FIGS. 6 to 8, or the configurations of the first receiving portion 532 or the second receiving portion 536 of FIGS. 9 to 10.

The configurations of the first receiving portion 632 or the second receiving portion 636 of FIGS. 11A to 11E may be partially or entirely identical to the configurations of the first receiving portion 432 or the second receiving portion 436 of FIGS. 6 to 7, or the configurations of the first receiving portion 532 or the second receiving portion 536 of FIGS. 9 to 10.

Referring to FIG. 11A, a manufacturing method (or manufacturing process) of the circuit board assembly 400 may include a process of preparing the first substrate 410 on which the first layer 431 is stacked. The first substrate 410 may include at least one first pad 411.

According to an embodiment, the first receiving portion 632 may be formed in a state in which the first layer 431 is stacked on the first substrate 410 or may be formed in a state before the first layer 431 is stacked on the first substrate 410.

According to an embodiment, the first receiving portion 632 may be formed through a plasma etching process (e.g., a plasma etching process using an ion beam), a chemical etching process (e.g., a wet etching process after adhering a masking tape in a state in which the first layer 431 is stacked on the first substrate 410), or a press process (e.g., a mechanical press process) on the first layer 431. Further, the first receiving portion 632 may be a stepped portion formed corresponding to a step formed in a process of stacking the first layer 431 on a step formed on one surface (a surface facing the electrical component 420) of the first substrate 410 (e.g., an internal portion of a mesh pattern formed by the line of the first substrate 410). Further, the first receiving portion 632 may be a stepped portion formed by stacking the first layer 431 in two stages when stacking the first layer 431.

According to an embodiment, a soldering member 450a (e.g., a solder ball, a stud bump, a pillar bump, or a metal paste) may be disposed on the at least one first pad 411.

According to an embodiment, the soldering member 450a may further include a flux for preventing the soldering member 450a (or the conductive member 450) from being oxidized in a thermal compressing process described below.

Referring to FIG. 11A, the manufacturing method (or manufacturing process) of the circuit board assembly 400 may include a process of disposing (or applying) a resin 640a (e.g., an epoxy resin or an acrylic resin) on an upper portion of the first layer 431.

For example, the process of disposing the resin 640a on the upper portion of the first layer 431 may be performed as a process of positioning the resin 640a applied (or stacked) on a release tape 10 on the upper portion of the first layer 431, as illustrated in FIG. 11A. Further, the process of disposing the resin 640a on the upper portion of the first layer 431 may be performed as a process of applying the resin 640a discharged from a dispenser on the upper portion of the first layer 431.

Referring to FIG. 11B, the process of disposing the resin 640a on the upper portion of the first layer 431 may further include a process of separating the release tape 10 from the resin 640a.

Referring to FIG. 11C, the manufacturing method (or manufacturing process) of the circuit board assembly 400 may include a process of preparing the electrical component 420 on which the second layer 435 is stacked. The electrical component 420 may include at least one second pad 421.

According to an embodiment, the second receiving portion 636 may be formed in a state in which the second layer 435 is stacked on the electrical component 420 or may be formed in a state before the second layer 435 is stacked on the electrical component 420.

According to an embodiment, the second receiving portion 636 may be formed through a plasma etching process (e.g., a plasma etching process using an ion beam), a chemical etching process (e.g., a wet etching process after adhering a masking tape in a state in which the second layer 435 is stacked on the electrical component 420), or a press process (e.g., a mechanical press process) on the second layer 435. Further, the second receiving portion 636 may be a stepped portion formed corresponding to a step formed in a process of stacking the second layer 435 on a step formed on one surface (a surface facing the first substrate 410) of the electrical component 420 (e.g., an internal portion of a mesh pattern formed by the line of the electrical component 420). Further, the second receiving portion 636 may be a stepped portion formed by stacking the second layer 435 in two stages when stacking the second layer 435.

Referring to FIG. 11C, the manufacturing method (or manufacturing process) of the circuit board assembly 400 may include a process of aligning the electrical component 420 on an upper portion of the first substrate 410.

According to an embodiment, the process of aligning the electrical component 420 on the upper portion of the first substrate 410 may be performed as a process of aligning the at least one second receiving portion 636 to correspond to the at least one first receiving portion 632.

Referring to FIG. 11D, the manufacturing method (or manufacturing process) of the circuit board assembly 400 may include a process of thermally compressing the first substrate 410 and the electrical component 420.

According to an embodiment, the electrical component 420 may be pressed by a pressing device 20 (e.g., a hot bar) that serves as a heat source and compressed to the first substrate 410.

According to an embodiment, when thermal compressing process is performed, the soldering member 450a may be melted to form the conductive member 450. The conductive member 450 may be combined with the at least one first pad 411 and the at least one second pad 421. Further, the conductive member 450 may be electrically connected to the at least one first pad 411 and the at least one second pad 421.

According to an embodiment, when thermal compressing process is performed, the resin 640a may be compressed by the electrical component 420 (or the second layer 435). According to an embodiment, the resin 640a may be pressed by the second layer 435. According to an embodiment, at least a portion of the resin 640a may be received in a space formed by the first receiving portion 632 and the second receiving portion 636 to form the first bonding resin 640. A remainder of the resin 640a may be pushed out to the outside of the first layer 431 and the second layer 435 to form the second bonding resin 445.

According to an embodiment, if the thermal compressing process is performed, the second layer 435 may be stacked on the first layer 431. For example, the second layer 435 may be bonded to the first layer 431. According to an embodiment, one surface of the second layer 435 (e.g., a surface facing the first layer 431) may be stacked on one surface of the first layer 431 (e.g., a surface facing the second layer 435).

According to an embodiment, except for the space formed by the first receiving portion 632 and the second receiving portion 636, the resin 640a may not be disposed between one surface of the first layer 431 and one surface of the second layer 435.

According to an embodiment, one surface of the first layer 431 may be defined as being directly contacted, connected, or combined with one surface of the second layer 435.

Referring to FIG. 11E, the manufacturing method (or manufacturing process) of the circuit board assembly 400 may further include a process of cooling the conductive member 450, the first bonding resin 640, or the second bonding resin 445.

According to an embodiment, the cooling process may be performed as a process of separating the pressing device 20 from the electrical component 420 and lowering the temperature of the circuit board assembly 400 if the thermal compressing process is completed.

According to an embodiment, if the cooling process is completed, the circuit board assembly 400 may be manufactured.

FIG. 12 is a plan view illustrating a first substrate according to an embodiment of the disclosure.

The embodiment of FIG. 12 may be combinable with the embodiments of FIGS. 1 to 11E, or the embodiments of FIGS. 13 to 17.

Referring to FIG. 12, the first substrate 410 (e.g., the first substrate 410 of FIGS. 6 to 11E) may include at least one first pad 411 (e.g., the at least one first pad 411 of FIGS. 6 to 11E).

According to an embodiment, the first layer 431 (e.g., the first layer 431 of FIGS. 6 to 11E) may be stacked on one surface of the first substrate 410.

According to an embodiment, the first layer 431 may include at least one first receiving portion 732 (e.g., the at least one first receiving portion 432 of FIGS. 6 to 8, the at least one first receiving portion 532 of FIGS. 9 to 10, or the at least one first receiving portion 632 of FIGS. 11A to 11E).

According to an embodiment, a cross-sectional shape of the at least one first receiving portion 732 (e.g., a cross-sectional shape of the at least one first receiving portion (e.g., the first receiving portion 732 of FIG. 12) when viewing the first substrate 410 from the electrical component 420 of FIGS. 6 to 7) may be a rectangular shape having a long side and a short side shorter than the long side, but is not limited thereto, and may have various shapes such as circular, elliptical, square, or polygonal shapes.

Although not illustrated, a cross-sectional shape of at least one second receiving portion (e.g., the at least one second receiving portion 436 of FIGS. 6 to 7, or the second receiving portion 536 of FIGS. 9 to 10) of a second layer (e.g., the second layer 435 of FIGS. 6 to 7, or FIGS. 9 to 11E) (e.g., a cross-sectional shape of the at least one second receiving portion when viewing the electrical component 420 from the first substrate 410 of FIGS. 6 to 7) may be substantially the same as the cross-sectional shape of the at least one first receiving portion 732. Further, the at least one first receiving portion 732 may be positioned corresponding to the at least one second receiving portion.

Although not illustrated, a cross-sectional shape of at least one second pad (e.g., the at least one second pad 421 of FIGS. 6 to 7) of an electrical component (e.g., the electrical component 420 of FIGS. 6 to 7) (e.g., a cross-sectional shape of the at least one second pad 421 when viewing the electrical component 420 from the first substrate 410 of FIGS. 6 to 7) may be substantially the same as the cross-sectional shape of the at least one first pad 411. Further, the at least one first pad 411 may be positioned corresponding to the at least one second pad.

According to an embodiment, the at least one first receiving portion 732 may include a 1-1th receiving portion 732a or a 1-2th receiving portion 732b.

According to an embodiment, the 1-2th receiving portion 732b may be spaced apart from the 1-1th receiving portion 732a. Further, the 1-2th receiving portion 732b may be disposed obliquely with respect to the 1-1th receiving portion 732a. According to an embodiment, the 1-2th receiving portion 732b may be disposed adjacent to a corner of the first layer 431, but the disclosure is not limited thereto.

According to an embodiment, the 1-1th receiving portion 732a may be defined as extending in a first direction, and the 1-2th receiving portion 732b may be defined as extending in a second direction that is different from the first direction.

According to an embodiment, the at least one second receiving portion may include a 2-1th receiving portion corresponding to the 1-1th receiving portion 732a and a 2-2th receiving portion corresponding to the 1-2th receiving portion 732b.

FIG. 13 is a plan view illustrating a first substrate according to an embodiment of the disclosure.

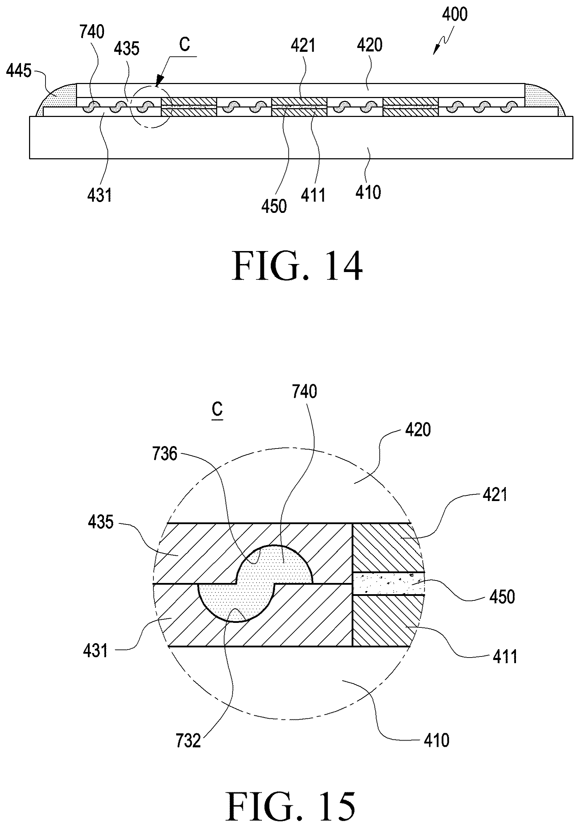

The embodiment of FIG. 13 may be combinable with the embodiments of FIGS. 1 to 12, or the embodiments of FIGS. 14 to 17.

Referring to FIG. 13, the first substrate 410 (e.g., the first substrate 410 of FIGS. 6 to 11E) may include at least one first pad 411 (e.g., the at least one first pad 411 of FIGS. 6 to 11E).

According to an embodiment, the first layer 431 (e.g., the first layer 431 of FIGS. 6 to 11E) may be stacked on one surface of the first substrate 410.

According to an embodiment, the first layer 431 may include at least one first receiving portion 832 (e.g., the at least one first receiving portion 432 of FIGS. 6 to 8, the at least one first receiving portion 532 of FIGS. 9 to 10, or the at least one first receiving portion 632 of FIGS. 11A to 11E).

According to an embodiment, a cross-sectional shape of the at least one first receiving portion 832 (e.g., a cross-sectional shape of the at least one first receiving portion (e.g., the first receiving portion 832 of FIG. 13) when viewing the first substrate 410 from the electrical component 420 of FIGS. 6 to 7) may be a rectangular shape having a long side and a short side shorter than the long side, but is not limited thereto, and may have various shapes such as circular, elliptical, square, or polygonal shapes.

Although not illustrated, a cross-sectional shape of at least one second receiving portion (e.g., the at least one second receiving portion 436 of FIGS. 6 to 7, or the second receiving portion 536 of FIGS. 9 to 10) of a second layer (e.g., the second layer 435 of FIGS. 6 to 7, or FIGS. 9 to 11E) (e.g., a cross-sectional shape of the at least one second receiving portion when viewing the electrical component 420 from the first substrate 410 of FIGS. 6 to 7) may be substantially the same as the cross-sectional shape of the at least one first receiving portion 832. Further, the at least one first receiving portion 832 may be positioned corresponding to the at least one second receiving portion.

Although not illustrated, a cross-sectional shape of at least one second pad (e.g., the at least one second pad 421 of FIGS. 6 to 7) of an electrical component (e.g., the electrical component 420 of FIGS. 6 to 7) (e.g., a cross-sectional shape of the at least one second pad 421 when viewing the electrical component 420 from the first substrate 410 of FIGS. 6 to 7) may be substantially the same as the cross-sectional shape of the at least one first pad 411. Further, the at least one first pad 411 may be positioned corresponding to the at least one second pad.

According to an embodiment, the at least one first receiving portion 832 may include a 1-1th receiving portion 832a or a 1-2th receiving portion 832b.

According to an embodiment, the 1-1th receiving portion 832a may be defined as extending in a first direction, and the 1-2th receiving portion 832b may be defined as extending in the first direction.

According to an embodiment, the 1-1th receiving portion 832a may not overlap the 1-2th receiving portion 832b with respect to the first direction.

According to an embodiment, the 1-1th receiving portion 832a and/or the 1-2th receiving portion 832b may not overlap other receiving portions with respect to a second direction perpendicular to the first direction.

According to an embodiment, the 1-1th receiving portion 832a and/or the 1-2th receiving portion 832b may be formed or disposed in the first layer 431 so as to be offset in a direction in which a flexible printed circuit board extends when, e.g., an electrical component (e.g., the electrical component 420 of FIGS. 6 to 7) is a component such as a flexible printed circuit board (e.g., the flexible printed circuit board 345 of FIGS. 4 to 5). For example, when external impact is applied to the flexible printed circuit board or an electronic device (e.g., the electronic device 101 of FIGS. 1 to 5), the 1-1th receiving portion 832a and/or the 1-2th receiving portion 832b may be intensively formed at a portion (or position) where the electrical component is separated from the first substrate 410. Accordingly, as a first bonding resin (e.g., the first bonding resin 440 of FIGS. 6 to 7, or the first bonding resin 540 of FIGS. 9 to 10) fills portions where bonding is weak, a robust bonding force may be provided between the first substrate 410 and the electrical component.

According to an embodiment, the at least one second receiving portion may include a 2-1th receiving portion corresponding to the 1-1th receiving portion 832a and a 2-2th receiving portion corresponding to the 1-2th receiving portion 832b.

FIG. 14 is a cross-sectional view illustrating a circuit board assembly according to an embodiment of the disclosure.

FIG. 15 is an enlarged view of portion C of FIG. 14 according to an embodiment of the disclosure.

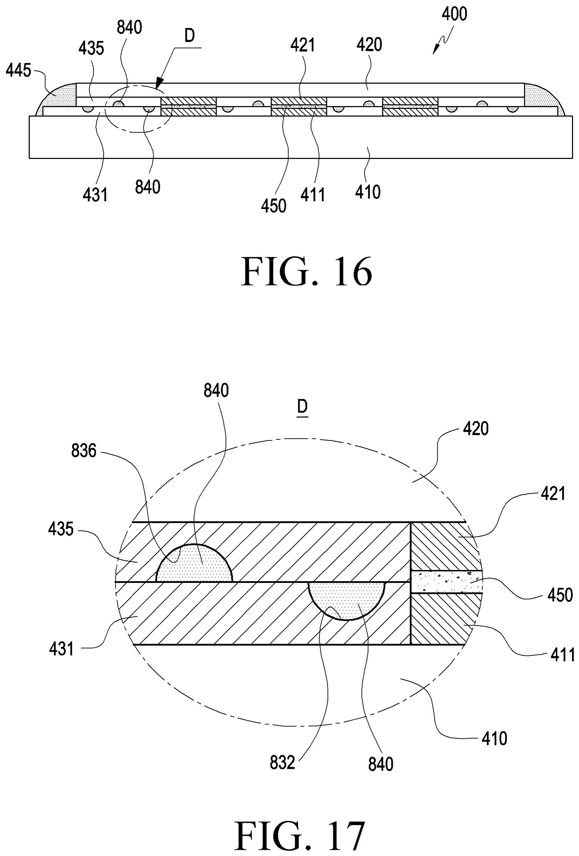

The embodiments of FIGS. 14 and 15 may be combined with the embodiments of FIGS. 1 and 13 or the embodiments of FIGS. 16 to 17.

The configurations of the circuit board assembly 400, the first circuit board 410, the at least one first pad 411, the electrical component 420, the at least one second pad 421, the first layer 431, the second layer 435, the first bonding resin 740, the second bonding resin 445, or the conductive member 450 of FIGS. 14 to 15 may be partially or entirely identical to the configurations of the circuit board assembly 400, the first circuit board 410, the at least one first pad 411, the electrical component 420, the at least one second pad 421, the first layer 431, the second layer 435, the first bonding resin 440, the second bonding resin 445, or the conductive member 450 of FIGS. 6 to 7.

The configurations of the first receiving portion 732 or the second receiving portion 736 of FIGS. 14 to 15 may be partially or entirely identical to the configurations of the first receiving portion 432 or the second receiving portion 436 of FIGS. 6 to 8, or the configurations of the first receiving portion 532 or the second receiving portion 536 of FIGS. 9 to 10.

According to an embodiment, the first layer 431 may include at least one first receiving portion 732. The at least one first receiving portion 732 may be defined as a groove or recess recessed from one surface of the first layer 431 (e.g., a surface facing the electrical component 420).

According to an embodiment, a maximum depth of the at least one first receiving portion 732 may be defined or referred to as a maximum height of the at least one first receiving portion 732.

According to an embodiment, the second layer 435 may include at least one second receiving portion 736. The at least one second receiving portion 736 may be defined as a groove or recess recessed from one surface of the second layer 435 (e.g., a surface facing the first substrate 410).

According to an embodiment, a maximum depth of the at least one second receiving portion 736 may be defined or referred to as a maximum height of the at least one second receiving portion 736.

According to an embodiment, a sum of the maximum depth of the at least one first receiving portion 732 and the maximum depth of the at least one second receiving portion 736 may be smaller than a sum of the thickness of the first layer 431 and the thickness of the second layer 435.

According to an embodiment, at least a portion of the at least one second receiving portion 736 may overlap at least a portion of the at least one first receiving portion 732 with respect to a thickness direction of the first layer 431 (or a thickness direction of the second layer 435).

According to an embodiment, a remainder of the at least one second receiving portion 736 may not overlap a remainder of the at least one first receiving portion 732 with respect to the thickness direction of the first layer 431 (or the thickness direction of the second layer 435).

According to an embodiment, the at least one first receiving portion 732 and the at least one second receiving portion 736 may provide a receiving space for disposing the first bonding resin 740.

According to an embodiment, a cross-sectional shape of the at least one first receiving portion 732 (or the at least one second receiving portion 736) may be semi-circular as in the illustrated embodiment, but the disclosure is not limited thereto. For example, the cross-sectional shape of the at least one first receiving portion 732 (or the at least one second receiving portion 736) may have a circular, elliptical, square, rhombic, rectangular, or various polygonal cross-sectional shape.

According to an embodiment, the first bonding resin 740 may be disposed in a space formed by the first receiving portion 732 and the second receiving portion 736 when the second layer 435 is stacked on the first layer 431.

According to an embodiment, the first bonding resin 740 may include at least one of an epoxy resin or an acrylic resin.

According to an embodiment, the first bonding resin 740 may enhance bonding strength between the first layer 431 and the second layer 435. For example, the first bonding resin 740 may enhance binding force between the first layer 431 and the second layer 435. Further, the first bonding resin 740 may mitigate impact directly applied to the first pad 411 or the second pad 421 when external impact is applied to the electronic device (or the circuit board assembly 400).

According to an embodiment, the first bonding resin 740 may be defined and/or referred to as an internal resin disposed inside the first layer 431 and the second layer 435, and the second bonding resin 445 may be defined and/or referred to as an external resin disposed outside the first layer 431 and the second layer 435.

According to an embodiment, the first receiving portion 732 (or the second receiving portion 736) may include a through hole, and the second receiving portion 736 (or the first receiving portion 732) may include a recessed groove or recess.

FIG. 16 is a cross-sectional view illustrating a circuit board assembly according to an embodiment of the disclosure.

FIG. 17 is an enlarged view of portion D of FIG. 16 according to an embodiment of the disclosure.

The embodiments of FIGS. 16 to 17 may be combined with the embodiments of FIGS. 1 to 15.

The configurations of the circuit board assembly 400, the first circuit board 410, the at least one first pad 411, the electrical component 420, the at least one second pad 421, the first layer 431, the second layer 435, the first bonding resin 840, the second bonding resin 445, or the conductive member 450 of FIGS. 16 to 17 may be partially or entirely identical to the configurations of the circuit board assembly 400, the first circuit board 410, the at least one first pad 411, the electrical component 420, the at least one second pad 421, the first layer 431, the second layer 435, the first bonding resin 440, the second bonding resin 445, or the conductive member 450 of FIGS. 6 to 7.

The configurations of the first receiving portion 832 or the second receiving portion 836 of FIGS. 16 to 17 may be partially or entirely identical to the configurations of the first receiving portion 432 or the second receiving portion 436 of FIGS. 6 to 8, the configurations of the first receiving portion 532 or the second receiving portion 536 of FIGS. 9 to 10, or the configurations of the first receiving portion 732 or the second receiving portion 736 of FIGS. 14 to 15.

According to an embodiment, the first layer 431 may include at least one first receiving portion 832. The at least one first receiving portion 832 may be defined as a groove or recess recessed from one surface of the first layer 431 (e.g., a surface facing the electrical component 420).

According to an embodiment, a maximum depth of the at least one first receiving portion 832 may be defined or referred to as a maximum height of the at least one first receiving portion 832.

According to an embodiment, the second layer 435 may include at least one second receiving portion 836. The at least one second receiving portion 836 may be defined as a groove or recess recessed from one surface of the second layer 435 (e.g., a surface facing the first substrate 410).

According to an embodiment, a maximum depth of the at least one second receiving portion 836 may be defined or referred to as a maximum height of the at least one second receiving portion 836.

According to an embodiment, a sum of the maximum depth of the at least one first receiving portion 832 and the maximum depth of the at least one second receiving portion 836 may be smaller than a sum of the thickness of the first layer 431 and the thickness of the second layer 435.

According to an embodiment, the at least one second receiving portion 836 may not overlap the at least one first receiving portion 832 with respect to a thickness direction of the first layer 431 (or a thickness direction of the second layer 435).

According to an embodiment, the at least one first receiving portion 832 and the at least one second receiving portion 836 may provide a receiving space for disposing the first bonding resin 840.

According to an embodiment, a cross-sectional shape of the at least one first receiving portion 832 (or the at least one second receiving portion 836) may be semi-circular as in the illustrated embodiment, but the disclosure is not limited thereto. For example, the cross-sectional shape of the at least one first receiving portion 832 (or the at least one second receiving portion 836) may have a circular, elliptical, square, rhombic, rectangular, or various polygonal cross-sectional shape.

According to an embodiment, the first bonding resin 840 may be disposed in a space formed by the first receiving portion 832 or a space formed by the second receiving portion 836 when the second layer 435 is stacked on the first layer 431.

According to an embodiment, the first bonding resin 840 may include at least one of an epoxy resin or an acrylic resin.

According to an embodiment, the first bonding resin 840 may enhance bonding strength between the first layer 431 and the second layer 435. For example, the first bonding resin 840 may enhance binding force between the first layer 431 and the second layer 435. Further, the first bonding resin 840 may mitigate impact directly applied to the first pad 411 or the second pad 421 when external impact is applied to the electronic device (or the circuit board assembly 400).

According to an embodiment, the first bonding resin 840 may be defined and/or referred to as an internal resin disposed inside the first layer 431 and the second layer 435, and the second bonding resin 445 may be defined and/or referred to as an external resin disposed outside the first layer 431 and the second layer 435.

According to an embodiment, the first receiving portion 832 (or the second receiving portion 836) may include a through hole, and the second receiving portion 836 (or the first receiving portion 832) may include a recessed groove or recess.

Recently, due to demands for high integration and high performance such as downsizing, thinning, and application of the latest antenna-related technologies of portable electronic devices, space for disposing a circuit board inside an electronic device is decreasing, but space occupied by components due to addition of various functions is increasing.

Accordingly, methods are being proposed in which a circuit board and electrical components of an electronic device are connected through fine pads rather than separate connectors. However, as electronic devices are downsized, the size and/or height of pads become excessively small, making it difficult to position an adhesive member for binding a circuit board and electrical components between the circuit board and the electrical components.

According to various embodiments of the disclosure, there may be provided a circuit board assembly capable of receiving a bonding resin for enhancing binding force between a circuit board and electrical components and an electronic device including the same.

The disclosure is not limited to the foregoing embodiments but various modifications or changes may rather be made thereto without departing from the spirit and scope of the disclosure.

According to various embodiments of the disclosure, bonding reliability for electrical connection between pads of a circuit board and electrical component pads may be enhanced.

Effects obtainable from the disclosure are not limited to the above-mentioned effects, and other effects not mentioned may be apparent to one of ordinary skill in the art from the following description.

According to an embodiment of the disclosure, an electronic device may comprise a housing 210, 301, a first substrate 410, a first layer 431, an electrical component 420, a second layer 435, a conductive member 450, or a first bonding resin 440, 540. The first substrate 410 may be disposed inside the housing. The first substrate 410 may include at least one first pad 411. The first layer 431 may be disposed on the first substrate. The first layer 431 may include at least one first receiving portion 432, 532. The electrical component 420 may be disposed inside the housing. The electrical component may include at least one second pad 421 positioned corresponding to the at least one first pad. The second layer 435 may be disposed on the electrical component. The second layer 435 may be stacked on the first layer. The second layer 435 may include at least one second receiving portion 436, 536. The conductive member 450 may be configured to electrically connect the at least one first pad and the at least one second pad. The first bonding resin 440, 540 may be disposed in the at least one first receiving portion and the at least one second receiving portion.

According to an embodiment, one surface of the second layer may tightly contact one surface of the first layer.

According to an embodiment, the first layer or the second layer may include a solder resist layer.

According to an embodiment, the at least one first receiving portion 432 may include a groove recessed from one surface of the first layer.

According to an embodiment, the at least one second receiving portion 436 may include a groove recessed from one surface of the second layer.

According to an embodiment, the at least one first receiving portion 532 may include a hole penetrating from one surface of the first layer toward another surface.

According to an embodiment, the at least one second receiving portion 536 may include a hole penetrating from one surface of the second layer toward another surface.

According to an embodiment, the first bonding resin may include at least one of an epoxy resin or an acrylic resin.

According to an embodiment, the electronic device may further comprise a second bonding resin 445 covering a side surface of the first layer or a side surface of the second layer.

According to an embodiment, the at least one first receiving portion 732 may include a 1-1th receiving portion 732a extending in a first direction, or a 1-2th receiving portion 732b extending in a second direction different from the first direction.

According to an embodiment, the at least one first receiving portion 832 may include a 1-1th receiving portion 832a extending in a first direction, or a 1-2th receiving portion 832b extending in the first direction and not overlapping the 1-1th receiving portion with respect to the first direction.

According to an embodiment of the disclosure, a circuit board assembly 400 may include a first substrate 410, a first layer 431, an electrical component 420, a second layer 435, a conductive member 450, or a first bonding resin 440, 540. The first substrate may include at least one first pad 411. The first layer 431 may be disposed on the first substrate. The first layer 431 may include at least one first receiving portion 432, 532. The electrical component 420 may include at least one second pad 421 positioned corresponding to the at least one first pad. The second layer 435 may be disposed on the electrical component. The second layer 435 may be stacked on the first layer. The second layer 435 may include at least one second receiving portion 436, 536. The conductive member 450 may be configured to electrically connect the at least one first pad and the at least one second pad. The first bonding resin 440, 540 may be disposed in the at least one first receiving portion and the at least one second receiving portion.

According to an embodiment, one surface of the second layer may tightly contact one surface of the first layer.

According to an embodiment, the first layer or the second layer may include a solder resist layer.

According to an embodiment, the first layer or the second layer may include a cover-lay layer.

According to an embodiment, the first bonding resin may include at least one of an epoxy resin or an acrylic resin.

According to an embodiment, the circuit board assembly may further include a second bonding resin 445 covering a side surface of the first layer or a side surface of the second layer.

According to an embodiment of the disclosure, a method for manufacturing a circuit board assembly 400 may comprise preparing a first substrate 410 on which a first layer 431 having at least one first receiving portion 632 is stacked. The method for manufacturing the circuit board assembly 400 may include disposing a resin 640a on an upper portion of the first layer. The method for manufacturing the circuit board assembly 400 may comprise preparing an electrical component 420 on which a second layer 435 having at least one second receiving portion 636 is stacked. The method for manufacturing the circuit board assembly 400 may comprise aligning the electrical component on an upper portion of the first substrate. The method for manufacturing the circuit board assembly 400 may comprise thermally compressing the first substrate and the electrical component.

According to an embodiment, the first substrate may include at least one first pad. The electrical component may include at least one second pad electrically connected to the at least one first pad.

According to an embodiment, the aligning may be a process of aligning the at least one second receiving portion to correspond to the at least one first receiving portion.

While the disclosure has been shown and described with reference to exemplary embodiments thereof, it will be apparent to those of ordinary skill in the art that various changes in form and detail may be made thereto without departing from the spirit and scope of the disclosure as defined by the following claims.

## Claims

1. An electronic device (101) comprising:
a housing (210, 301);
a first substrate (410) disposed inside the housing and including at least one first pad (411);
a first layer (431) disposed on the first substrate and including at least one first accommodating portion (432, 532);
an electrical component (420) disposed inside the housing and including at least one second pad (421) positioned corresponding to the at least one first pad;
a second layer (435) disposed on the electrical component, stacked on the first layer, and including at least one second accommodating portion (436, 536);
a conductive member (450) configured to electrically connect the at least one first pad and the at least one second pad; and
a first bonding resin (440, 540) disposed in the at least one first receiving portion and the at least one second receiving portion.

2. The electronic device of claim 1, wherein one surface of the second layer tightly contacts one surface of the first layer.

3. The electronic device of claim 1 or 2, wherein the first layer or the second layer includes a solder resist layer.

4. The electronic device of any one of claims 1 to 3, wherein the at least one first accommodating portion (432) includes a groove recessed from one surface of the first layer.

5. The electronic device of any one of claims 1 to 4, wherein the at least one second accommodating portion (436) includes a groove recessed from one surface of the second layer.

6. The electronic device of any one of claims 1 to 5, wherein the at least one first accommodating portion (532) includes a hole penetrating from one surface of the first layer toward another surface.

7. The electronic device of any one of claims 1 to 6, wherein the at least one second accommodating portion (536) includes a hole penetrating from one surface of the second layer toward another surface.

8. The electronic device of any one of claims 1 to 7, wherein the first bonding resin includes at least one of an epoxy resin or an acrylic resin.

9. The electronic device of any one of claims 1 to 8, further comprising
a second bonding resin (445) covering a side surface of the first layer or a side surface of the second layer.

10. The electronic device of any one of claims 1 to 9, wherein the at least one first accommodating portion (732) includes:
a 1-1th accommodating portion (732a) extending in a first direction; and
a 1-2th accommodating portion (732b) extending in a second direction different from the first direction.

11. The electronic device of any one of claims 1 to 10, wherein the at least one first receiving portion (832) includes:
a 1-1th accommodating portion (832a) extending in a first direction; and
a 1-2th accommodating portion (832b) extending in the first direction and not overlapping the 1-1th receiving portion with respect to the first direction.

12. A method for manufacturing a circuit board assembly (400), the method comprising:
preparing a first substrate (410) on which a first layer (431) having at least one first accommodating portion (632) is stacked;
disposing a resin (640a) on an upper portion of the first layer;
preparing an electrical component (420) on which a second layer (435) having at least one second accommodating portion (636) is stacked;
aligning the electrical component on an upper portion of the first substrate; and
thermally compressing the first substrate and the electrical component.

13. The method of claim 12, wherein the first substrate includes at least one first pad, and wherein the electrical component includes at least one second pad electrically connected to the at least one first pad.

14. The method of claim 12 or 13, wherein the aligning is a process of aligning the at least one second receiving portion to correspond to the at least one first receiving portion.
